# EUROPEAN PATENT SPECIFICATION

(11) **EP 0 717 438 B1**
(45) Date of publication and mention of the grant of the patent: **23.04.2003**
(21) Application number: 95306730.3
(22) Date of filing: 25.09.1995
(51) Int. Cl.: H01L 21/768

(54) **Method for forming side contact of semiconductor device**
Verfahren zur Herstellung eines Seitenkontakts auf einer halbleitenden Anordnung
Procédé de fabrication d'un contact latéral sur un composant semi-conducteur

(30) Priority: 14.12.1994 KR 9434249
(43) Date of publication of application: 19.06.1996
(73) Proprietor: SAMSUNG ELECTRONICS CO., LTD., Suwon-city, Kyungki-do 441-373 (KR)
(72) Inventor: Shin, Heon-jong, Kwanak-gu, Seoul (KR)
(74) Representative: Musker, David Charles

(56) References cited:
- US-A- 4 874 719
- US-A- 5 204 286

## Description

### Background of the Invention

The present invention relates to a method for forming a side contact of a semiconductor device, and more particularly, to a method for forming a side contact of a semiconductor device which can reduce contact resistance by changing a natural oxide film of the side contact into a conductive material.

In general, as supply voltage decreases with reductions in device dimensions, memory cell stability during read/write operations is becoming an increasingly important issue in the development of semiconductor devices, for example, a static random access memory (SRAM). For 16Mb SRAMs, a symmetrically split word line cell is proposed to prevent the degradation of cell stability. In the split word line cell, however, each cell has two word lines and a very tight bit line pitch is required, thereby causing problems in that cell size reduction is difficult and high speed operation is difficult to achieve. In order to overcome these problems, a center word line cell structure having the word lines located in the center of each cell has been disclosed (see *IEDM* '93, pp817∼820).

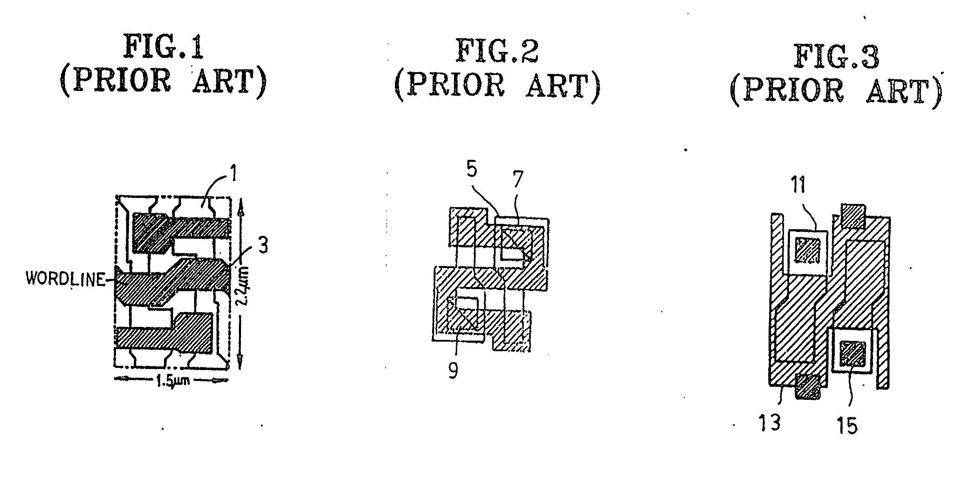

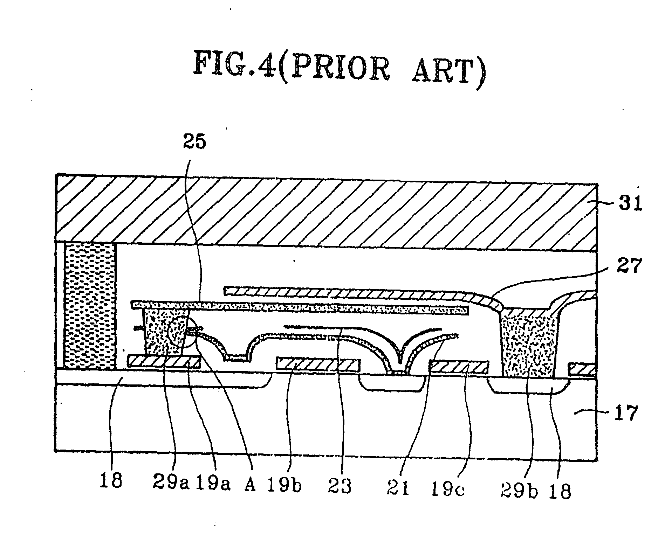

FIGS. 1-3 show the layouts of the center word line cell. More specifically, FIG. 1 is the layout of a bulk transistor, and FIGS. 2 and 3 are the layout of a thin-film transistor (TFT) and a capacitor, respectively. Here, reference numerals 1, 3 and 5 denote an active layer, a first polysilicon layer for a word line and driving transistor, and a TFT gate electrode, respectively; and reference numerals 7, 9, 11, 13 and 15 denote a TFT channel, a self-aligned contact, a capacitor electrode, a ground plate and a side contact, respectively.

The above center word line cell has a symmetrical layout and word line (first polysilicon layer) 3 is located in the center of the cell. Such a cell structure can save space for the additional word line used in the split word line cell, so that cell size reduction can be achieved while enough space is secured for a bit-line pitch.

FIG. 4 is a cross-sectional view of the above center word line cell.

Basically, the center word line cell is made of five layers of polysilicon. An impurity region 18 is formed on a substrate 17 and these five layers consist of first polysilicon patterns 19a, 19b and 19c used for an access transistor and a driving transistor, a second polysilicon layer 21 used as a load TFT gate electrode on the center of the cell, a third polysilicon layer 23 as a TFT channel, a fourth polysilicon layer 25 used as a capacitor electrode, and a fifth polysilicon layer 27 used as a ground plate. Also, reference numeral 31 denotes a bit line.

The center word line cell adopts a side contact (see area "A" of FIG. 4). First polysilicon plug 29a is simultaneously connected to first, second, third and fourth polysilicon layers 19a, 21, 23 and 25. Especially, first polysilicon plug 29a is connected to each side of second and third polysilicon layers 21 and 23. Also, second polysilicon plug 29b is connected between ground plate 27 and impurity region 18 of substrate 17.

The above side contact will now be explained in detail.

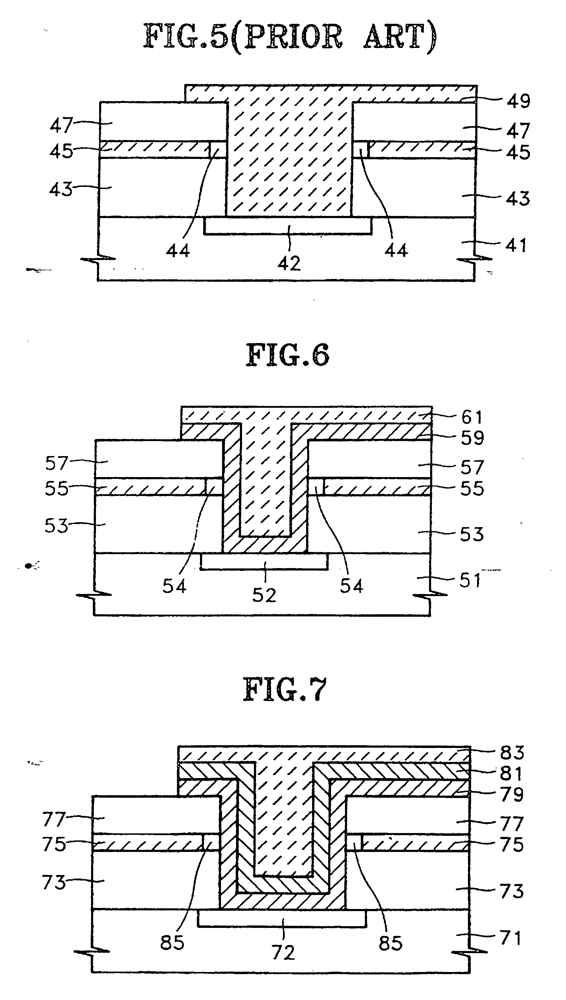

FIG. 5 is a cross-sectional view of a conventional side contact. Here, an impurity region 42 is selectively formed on substrate 41. First insulating layer 43, first conductive layer (polysilicon layer) 45 and second insulating layer 47, each having a contact hole, are formed on substrate 41 where impurity region 42 is formed. Second conductive layer (polysilicon plug) 49 for filling the contact hole is formed on the resultant structure.

In the above structure of the conventional side contact, a natural oxide layer 44 is formed on the side of first conductive layer 45. Owing to natural oxide layer 44 in the side contact, when the side contact is formed between first conductive layer (the TFT channel 23 in FIG. 4) 45 and second conductive layer (the polysilicon plugs in FIG. 4) 49, the contact resistance thereof is increased. If this increase is too great, the connection may ultimately prove impossible.

Reference is made to prior-art document US-A-5,204,286.

### Summary of the Invention

An object of the present invention is to provide a method for forming a side contact of a semiconductor device which can reduce contact resistance when the side contact is formed.

To achieve the above object, there is provided a method for forming a side contact of a semiconductor device as claimed in claim 1.

The refractory metal layer is formed by using a transition metal with a high melting point and a high oxygen solubility, for example, titanium (Ti), tantalum (Ta), molybdenum (Mo), platimum (Pt) or tungsten (W).

The step for changing the natural oxide layer into a conductive material is performed by the reaction of the natural oxide layer and the refractory metal layer. The second conductive layer is formed by using a composite layer including a polysilicon layer or a tungsten layer.

According to another embodiment of the present invention, there is a method of forming a side contact of a semiconductor device as claimed in claim 6.

The refractory metal layer is formed by using a transition metal with a high oxygen solubility. Also, the refractory metal layer and the diffusion preventing layer are formed using titanium and titanium nitride, respectively.

The step of changing the natural oxide layer into a conductive layer is carried out by the reaction of the natural oxide layer and the refractory metal layer. The second conductive layer is formed by using a composite layer including a polysilicon layer or a tungsten layer.

According to the present invention, a natural oxide layer formed on the side of a conductive layer is changed into a conductive material, thereby achieving a reduction in contact resistance and stabilization of the contact itself.

### Brief Description of the Drawings

The above objects and advantages of the present invention will become more apparent by describing in detail a preferred embodiment thereof with reference to the attached drawings in which:
FIGS. 1-3 are the layouts of a center word line cell according to prior art;
FIG. 4 is a cross-sectional view of a center word line cell of the prior art;
FIG. 5 is a cross-sectional view of a structure of a side contact of the prior art;
FIG. 6 is a cross-sectional view of a structure of a side contact according to one embodiment of the present invention;
FIG. 7 is a cross-sectional view of a structure of a side contact according to another embodiment of the present invention;
FIGS. 8-11 are cross-sectional views for sequentially illustrating the method for forming a side contact according to a first embodiment of the present invention; and
FIGS. 12 and 13 are cross-sectional views for sequentially illustrating the method for forming a side contact according to a second embodiment of the present invention.

### Detailed Description of the Invention

First, the structure of a side contact according to the present invention will be explained.

FIG. 6 is a cross-sectional view of a structure of a side contact according to one embodiment of the present invention.

As shown in FIG. 6, impurity region 52 is selectively formed on substrate 51. First insulating layer 53, first conductive layers 55 and second insulating layer 57, each having a contact hole, are formed on substrate 51 where impurity region 52 is formed. Refractory metal layer 59 is formed in the contact hole and on substrate 51. Second conductive layer (polysilicon plug) 61 for filling the contact hole is formed on the resultant structure.

In the structure of a side contact according to the present invention, a natural oxide layer formed on the side of first conductive layer 55 reacts with refractory metal layer 59 in the succeeding process, and is then changed into conductive material 54, thereby reducing a contact resistance when a side contact is formed between first conductive layer (TFT channel in FIG. 4) 55 and second conductive layer (polysilicon plug in FIG. 4) 61.

FIG. 7 is a cross-sectional view of structure of a side contact according to another embodiment of the present invention.

As shown in FIG. 7, impurity region 72 is selectively formed on substrate 71. First insulating layer 73, first conductive layer 75 and second insulating layers 77, each having a contact hole, are formed on substrate 71 where impurity region 72 is formed. Refractory metal layer 79 is formed in the contact hole and on substrate 71. Also, diffusion preventing layer 81 is formed on refractory metal layer 79, and second conductive layer 83 for filling the contact hole is formed on diffusion preventing layer 81.

In the structure of a side contact according to the present invention, the natural oxide layer formed on the side of first conductive layer 75 reacts with refractory metal layer 79 in the succeeding process, and is then changed into conductive material 85, thereby reducing a contact resistance when a side contact is formed between first conductive layer (TFT channel in FIG. 4) 75 and second conductive layer (polysilicon plug in FIG. 4) 83.

Hereinafter, a manufacturing method of the side contact structure will be described.

### First Embodiment

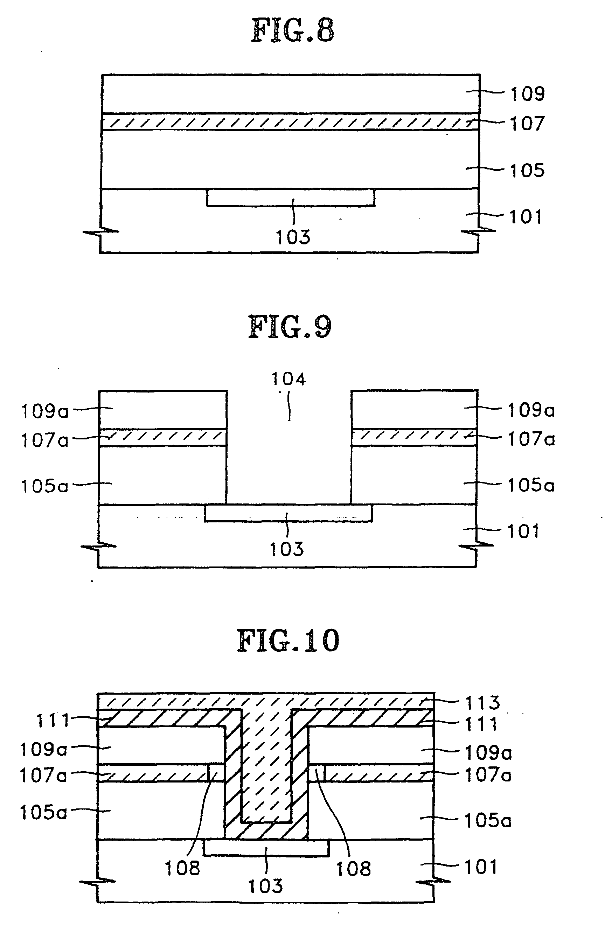

FIGS. 8-11 are cross-sectional views for sequentially illustrating the method for forming a side contact according to a first embodiment of the present invention.

FIG. 8 shows a step of forming first insulating layer 105, first conductive.layer 107 and second insulating layer 109. More specifically, after selectively forming impurity region 103 on substrate 101, first insulating layer 105, for example, an oxide layer, is then formed on substrate 101 where impurity region 103 is formed. First conductive layer 107, for example, polysilicon layer, is formed on first insulating layer 105. Then, second conductive layer, for example, an oxide layer, is formed on first conductive layer 107.

FIG. 9 shows a step of forming a contact hole 104. More specifically, second insulating layer 109, first conductive layer 107 and second insulating layer 105 are sequentially etched to form second insulating layer 109a, first conductive layer 107a and first insulating layer 105a, each having a contact hole 104.

FIG. 10 shows a step of forming refractory metal layer 111 and second conductive layer 113. First, natural oxide layer 108 is inherently formed on the sidewall of first conductive layer 107a while the resultant structure is exposed to air, as in a transition period before the succeeding process. Refractory metal layer 111, for example, a titanium layer, is formed on the sidewalls of second insulating layer 109a, natural oxide layer 108 and first insulating layer 105a, and on substrate 101. Next, second conductive layer 113, for example, a polysilicon layer, is formed so as to filling contact hole 104 on substrate 101 where refractory metal layer 111 is formed. Second conductive layer 113 can be formed using a composite layer including a polysilicon layer and a tungsten layer.

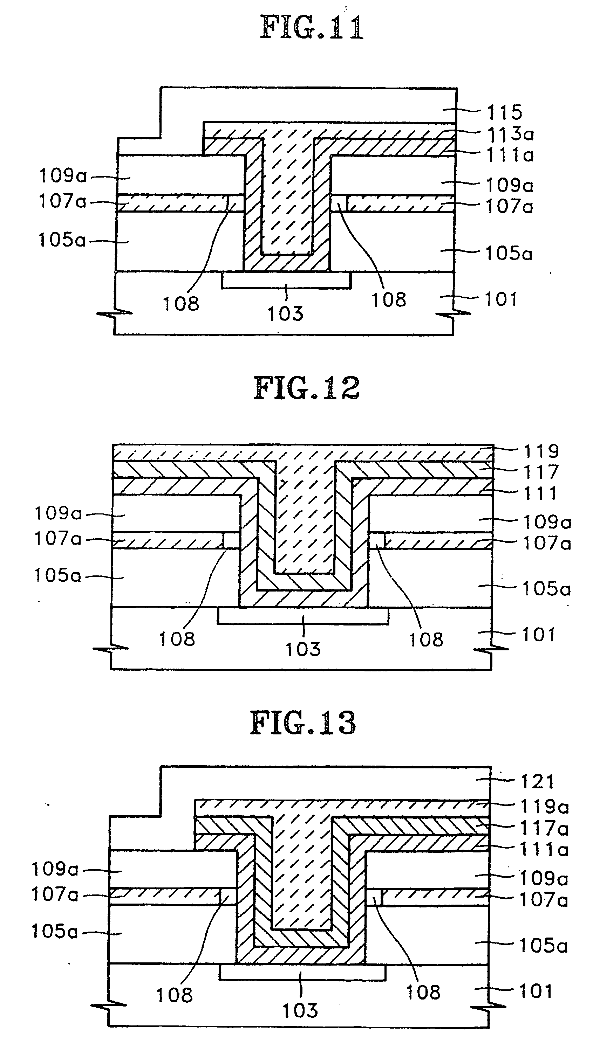

FIG. 11 shows a step of forming third insulating layer 115. More specifically, after forming second conductive layer 113a and refractory metal layer 111a patterned through a photolithography, third insulating layer 115 for insulating the second conductive layer is formed on the overall surface of the resultant structure.

After forming third insulating layer 115, natural oxide layer 108 formed on the sidewall of first conductive layer 107a is changed into a conductive material such as TiSiₓO_{y}, by the reaction of the natural oxide layer with refractory metal layer 111a at a temperature of 700-900°C. This preferably occurs during the succeeding process, e.g., a reflow process of a borophosphosilicate glass (BPSG) layer used for planarization prior to the deposition of a metal layer.

### Second Embodiment

FIGS. 12 and 13 are cross-sectional views for sequentially illustrating the method for forming a side contact according to a second embodiment of the present invention. In this embodiment, the first two steps, i.e., the steps shown in FIG. 8 and 9, are the same as those in the first embodiment. The same reference numerals represent the same members.

FIG. 12 shows a step of forming refractory metal layer 111, diffusion preventing layer 117 and second conductive layer 119. Natural oxide layer 108 is formed on the sidewall of first conductive layer 107a while the resultant structure is exposed to air, as in a transition period before the succeeding process. Refractory metal layer 111, for example, a titanium layer, is formed on the sidewalls of second insulating layer 109a, natural oxide layer 108 and first insulating layer 105a and on substrate 101. Next, diffusion preventing layer 117, for example, a titanium nitride layer, is formed on refractory metal layer 111. Then, second conductive layer 119, for example, a polysilicon layer, is formed on substrate 101 where the diffusion preventing layer 117 is formed so as to fill contact hole 104. Second conductive layer 119 can be formed by using a composite layer including a polysilicon layer or a tungsten layer.

FIG. 13 shows a step of forming third insulating layer 121. More specifically, after forming second conductive layer 119a, diffusion preventing layer 117a and refractory metal layer 111a patterned through photolithography, third insulating layer 121 for insulating the second conductive layer and a predetermined layer of the succeeding process is formed on the overall surface of the resultant structure.

After forming third insulating layer 121, natural oxide layer 108 formed on the sidewall of first conductive layer 107a is changed into a conductive material such as TiSiₓO_{y}, by the reaction of the natural oxide layer with refractory metal layer 111a at a temperature of 700-900°C. This preferably occurs during the succeeding process, e.g., a reflow process of a BPSG layer used for planarization prior to the deposition of a metal layer.

According to the present invention, a natural oxide layer formed on the sidewall of a conductive layer is changed into a conductive layer, thereby achieving the reduction of a contact resistance of a semiconductor device and the stabilization of a contact.

## Claims

1. A method for forming a side contact of a semiconductor device, comprising the sequential steps of:
forming a first insulating layer (53) on a semiconductor substrate (51);
forming a first conductive layer (55) and a second insulating layer (57) on said first insulating layer (53);
etching said second insulating layer (57), said first conductive layer (55) and said first insulating layer (53) to form a contact hole exposing a side of said first conductive layer (55);
forming a natural oxide layer (54) on the sidewall of the first conductive layer (55).
forming a refractory metal layer (59) on the exposed surface of the device and in said contact hole so as to cover the side of said first conductive layer;
forming a second conductive layer (61) on said refractory metal layer (59) so as to fill said contact hole; and
changing the natural oxide layer (54) into a conductive material.

2. A method for forming a side contact of a semiconductor device as claimed in claim 1, wherein said refractory metal layer is formed by using a transition metal with a high oxygen solubility.

3. A method for forming a side contact of a semiconductor device as claimed in claim 1, wherein said refractory metal layer is formed by using titanium.

4. A method for forming a side contact of a semiconductor device as claimed in claim 1, wherein said step of changing said natural oxide layer into a conductive material is performed by the reaction of said natural oxide layer and said refractory metal layer.

5. A method for forming a side contact of a semiconductor device as claimed in claim 1, wherein said second conductive layer is formed by using a composite layer including a polysilicon layer or a tungsten layer.

6. A method as claimed in claim 1 wherein after the formation of the refractory metal layer the method comprises the steps of:
forming a diffusion preventing layer on the refractory metal layer;
forming a second conductive layer on said diffusion preventing layer so as to fill said contact hole; and
changing a natural oxide layer formed on the side of said first conductive layer into a conductive material.

7. A method for forming a side contact of a semiconductor device as claimed in claim 6, wherein said diffusion preventing layer is formed by using titanium nitride.

## Patentansprüche

1. Verfahren zum Bilden eines Seitenkontakts eines Halbleiterbauelements mit folgender Schrittreihenfolge:
Bilden einer ersten Isolierschicht (53) auf einem Halbleitersubstrat (51);
Bilden einer ersten leitenden Schicht (55) und einer zweiten Isolierschicht (57) auf der ersten Isolierschicht (53);
Ätzen der zweiten Isolierschicht (57), der ersten leitenden Schicht (55) und der ersten Isolierschicht (53), um eine Kontaktöffnung zu bilden, die eine Seite der ersten leitenden Schicht (55) freilegt;
Bilden einer natürlichen Oxidschicht (54) an einer Seitenwand der ersten leitenden Schicht (55);
Bilden einer hitzebeständigen Metallschicht (59) auf der freigelegten Fläche des Bauelements und in der Kontaktöffnung, so daß die Seite der ersten leitenden Schicht bedeckt ist;
Bilden einer zweiten leitenden Schicht (61) auf der hitzebeständigen Metallschicht (59), so daß die Kontaktöffnung ausgefüllt wird; und
Ändern der natürlichen Oxidschicht (54) in ein leitendes Material.

2. Verfahren nach Anspruch 1, wobei die hitzebeständige Metallschicht dadurch gebildet wird, daß ein Übergangsmetall mit einer hohen Sauerstofflöslichkeit verwendet wird.

3. Verfahren nach Anspruch 1, wobei die hitzebeständige Metallschicht dadurch gebildet wird, daß Titan verwendet wird.

4. Verfahren nach Anspruch 1, wobei das Ändern der natürlichen Oxidschicht in ein leitendes Material durch eine Reaktion der natürlichen Oxidschicht und der hitzebeständigen Metallschicht herbeigeführt wird.

5. Verfahren nach Anspruch 1, wobei die zweite leitende Schicht dadurch gebildet wird, daß eine zusammengesetzte Schicht, die eine Polysiliziumschicht oder eine Wolframschicht umfasst, verwendet wird.

6. Verfahren nach Anspruch 1, wobei das Verfahren nach dem Bilden der hitzebeständigen Metallschicht folgende Schritte umfaßt:
Bilden einer Diffusionsverhinderungsschicht auf der hitzebeständigen Metallschicht;
Bilden einer zweiten leitenden Schicht auf der Diffusionsverhinderungsschicht, so daß die Kontaktöffnung ausgefüllt wird; und
Ändern der natürlichen Oxidschicht, die auf der Seite der ersten leitenden Schicht gebildet ist in ein leitendes Material.

7. Verfahren nach Anspruch 6, wobei die Diffusionsverhinderungsschicht dadurch gebildet wird, daß Titannitrid verwendet wird.

## Revendications

1. Procédé pour former un contact latéral d'un dispositif à semiconducteur, comprenant les étapes séquentielles consistant à :
former une première couche isolante (53) sur un substrat semiconducteur (51) ;
former une première couche conductrice (55) et une deuxième couche isolante (57) sur ladite première couche isolante (53) ;
effectuer une attaque chimique sur ladite deuxième couche isolante (57), ladite première couche conductrice (55) et ladite première couche isolante (53) pour former un trou de contact qui expose un côté de ladite première couche conductrice (55) ;
former une couche d'oxyde naturel (54) sur la paroi latérale de la première couche conductrice (55) ;
former une couche de métal réfractaire (59) sur la surface exposée du dispositif et dans ledit trou de contact de manière à couvrir le côté de ladite première couche conductrice ;
former une deuxième couche conductrice (61) sur ladite couche de métal réfractaire (59) de manière à remplir ledit trou de contact ; et
transformer la couche d'oxyde naturel (54) en un matériau conducteur.

2. Procédé pour former un contact latéral d'un dispositif à semiconducteur selon la revendication 1, dans lequel ladite couche de métal réfractaire est formée en utilisant un métal de transition à haute solubilité de l'oxygène.

3. Procédé pour former un contact latéral d'un dispositif à semiconducteur selon la revendication 1, dans lequel ladite couche de métal réfractaire est formée en utilisant du titane.

4. Procédé pour former un contact latéral d'un dispositif à semiconducteur selon la revendication 1, dans lequel ladite étape de transformation de ladite couche d'oxyde naturel en un matériau conducteur est exécutée par la réaction de ladite couche d'oxyde naturel et de ladite couche de métal réfractaire.

5. Procédé pour former un contact latéral d'un dispositif à semiconducteur selon la revendication 1, dans lequel ladite deuxième couche conductrice est formée en utilisant une couche composite comportant une couche de silicium polycristallin ou une couche de tungstène.

6. Procédé selon la revendication 1, dans lequel, après la formation de la couche de métal réfractaire, le procédé comprend les étapes consistant à :
former une couche empêchant la diffusion sur la couche de métal réfractaire ;
former une deuxième couche conductrice sur ladite couche empêchant la diffusion de manière à remplir ledit trou de contact ; et
transformer une couche d'oxyde naturel formée sur le côté de ladite première couche conductrice en un matériau conducteur.

7. Procédé pour former un contact latéral d'un dispositif à semiconducteur selon la revendication 6, dans lequel ladite couche empêchant la diffusion est formée en utilisant du nitrure de titane.
